# EUROPEAN PATENT SPECIFICATION

(11) **EP 3 340 446 B1**
(45) Date of publication and mention of the grant of the patent: **02.09.2020**
(21) Application number: 17200783.3
(22) Date of filing: 09.11.2017
(51) Int. Cl.: H02M 1/088, H03K 17/0812, H03K 17/74

(54) **SEMICONDUCTOR APPARATUS AND INVERTER SYSTEM**
HALBLEITERVORRICHTUNG UND UMRICHTERSYSTEM
APPAREIL SEMI-CONDUCTEUR ET SYSTÈME D'ONDULEUR

(30) Priority: 22.12.2016 JP 2016249055
(43) Date of publication of application: 27.06.2018
(73) Proprietor: Renesas Electronics Corporation, Tokyo 135-0061 (JP)
(72) Inventor: Kondo, Daisuke, Tokyo 135-0061 (JP)
(74) Representative: Betten & Resch

(56) References cited:
- EP-A2- 2 597 767
- DE-A1- 10 301 693
- US-A1- 2014 203 848
- US-A1- 2014 218 099

## Description

### CROSS-REFERENCE TO RELATED APPLICATIONS

This application is based upon and claims the benefit of priority from Japanese patent application No. 2016-249055, filed on December 22, 2016.

### BACKGROUND

The present disclosure relates to a semiconductor apparatus and an inverter system. For example, the present disclosure relates to a semiconductor apparatus and an inverter system including a power transistor.

In a system that drives a motor with high power or performs energy conversion and the like, a power transistor (three-terminal amplifying element) such as an IGBT (Insulated Gate Bipolar Transistor) or a Power MOSFET (Metal Oxide Semiconductor Field Effect Transistor) is widely used. Since the use of such a system has been expanding recently, there is an increasing need for driving a load with higher power.

In this regard, in order to enable switching with high power, a method for connecting a plurality of power transistors in parallel is known (e.g., Fuji Electric Co., Ltd. "PrimePack (registered trademark) Module Parallel Connection", [online], <URL : https://www.fujielectric.co.jp/products/semiconductor/model/ig bt/application/box/doc/pdf/RH984b/Parallel%20connection_PP_J.p df> and International Rectifier, "Application Note": AN-941 Power MOSFET Parallel Connection, [online], <URL ; http://www.infineon.com/dgdl/AN-941J.pdf?fileId=5546d46256fb43b301574c6033177c39>). US20140218099 discloses an apparatus which includes switching elements and resonance suppression resistors. DE10301693 discloses a Mosfet for switched power mode semiconductors that has two transistors with a Zener diode switching off device to reduce output voltage oscillations.

### SUMMARY

As described above, along with the increase in power of the output, the number of parallel connections of power transistors is increasing. However, the present inventors have found a problem in a related technique that when power transistors are connected in parallel, the performance may deteriorate. Thus, one of objects of an aspect of the present disclosure is to improve the performance of a semiconductor apparatus.

Other problems of the related art and new features of the present disclosure will become apparent from the following descriptions of the specification and attached drawings. The present invention is defined by the features of the appended claims.

According to an aspect, a semiconductor apparatus includes first and second power transistors, a first resistor, and a first diode. The first and second power transistors are connected in parallel to each other. The first resistor is connected to a control terminal of the first power transistor. The first diode is connected in parallel to the first resistor. In the first diode, a direction toward the control terminal of the first power transistor is a forward direction.

According to the above aspect, it is possible to improve performance of a semiconductor apparatus.

### BRIEF DESCRIPTION OF THE DRAWINGS

The above and other aspects, advantages and features will be more apparent from the following description of certain embodiments taken in conjunction with the accompanying drawings, in which:
Fig. 1 is a configuration diagram showing a configuration example of a wind power generation system according to a first embodiment;
Fig. 2 is a schematic cross-sectional diagram showing an example of an IGBT element according to the first embodiment;
Fig. 3 is a circuit diagram showing an example of an equivalent circuit of the IGBT element according to the first embodiment;
Fig. 4 is a schematic cross-sectional diagram showing another example of the IGBT element according to the first embodiment;
Fig. 5 is a circuit diagram showing another example of the equivalent circuit of the IGBT element according to the first embodiment;
Fig. 6 is a configuration diagram showing a configuration example of a drive system including an IGBT module according to Study Example;
Fig. 7 is a waveform diagram showing signals when a load is short-circuited in the IGBT module of Study Example;
Fig. 8 is a configuration diagram including an equivalent circuit of a resonant loop in the IGBT module of Study Example;
Fig. 9 is a circuit diagram showing a configuration of the equivalent circuit of the resonant loop in the IGBT module of Study Example;
Fig. 10 is a configuration diagram showing a configuration example of a drive system including an IGBT module according to the first embodiment;
Fig. 11 is a configuration diagram of a configuration including an equivalent circuit of a resonant loop in the IGBT module according to the first embodiment;
Fig. 12 is a circuit diagram showing a configuration of the equivalent circuit of the resonant loop in the IGBT module according to the first embodiment;
Fig. 13 is a configuration diagram showing another configuration example of the IGBT module according to the first embodiment;
Fig. 14 is a configuration diagram corresponding to Implementation Example of the IGBT module of Reference Example;
Fig. 15 is a schematic plan view corresponding to Implementation Example of the IGBT module of Reference Example;
Fig. 16 is a configuration diagram corresponding to Implementation Example 1 of an IGBT module according to the second embodiment;
Fig. 17 is a schematic plan view corresponding to Implementation Example 1 of an IGBT module according to the second embodiment;
Fig. 18 is a schematic plan view corresponding to another Implementation Example of the IGBT module according to the second embodiment;
Fig. 19 is a configuration diagram corresponding to Implementation Example 2 of an IGBT module according to the second embodiment;
Fig. 20 is a schematic plan view corresponding to Implementation Example 2 of the IGBT module according to the second embodiment;
Fig. 21 is a configuration diagram corresponding to Implementation Example 3 of an IGBT module according to the second embodiment; and
Fig. 22 is a schematic plan view corresponding to Implementation Example 3 of the IGBT module according to the second embodiment.

### DETAILED DESCRIPTION

For the clarification of the description, the following description and the drawings may be omitted or simplified as appropriate. Further, each element shown in the drawings as functional blocks that perform various processing can be formed of a CPU (Central Processing Unit), a memory, and other circuits in hardware and may be implemented by programs loaded in the memory in software. Those skilled in the art will therefore understand that these functional blocks may be implemented in various ways by only hardware, only software, or the combination thereof without any limitation. Throughout the drawings, the same components are denoted by the same reference signs and overlapping descriptions will be omitted as appropriate.

### First Embodiment

Hereinafter, a first embodiment will be described with reference to the drawings.

### <Configuration of System of First Embodiment>

As a system according to a first embodiment, a wind power generation system will be described below. Note that the wind power generation system is an example of a system (inverter system) using a power device such as IGBT. The system may be an industrial motor driving system, another energy power conversion system, or the like.

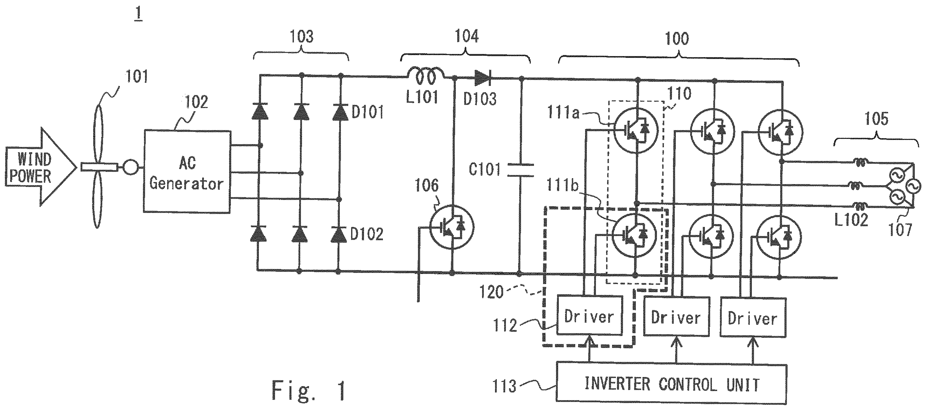

Fig. 1 shows a configuration example of a wind power generation system according to this embodiment. As shown in Fig. 1, the wind power generation system 1 according to this embodiment includes a wind turbine 101, an AC input unit (AC generator) 102, a rectifier 103, a booster 104, an inverter 100, and an AC output unit 105. The wind power generation system 1 further includes driver modules 112 and an inverter control unit (inverter control microcomputer) 113. The driver modules 112 drive IGBT circuits 111a and 111b. The driver modules 112 and the inverter control unit 113 constitute the inverter 100.

The AC input unit 102 is a generator that generates AC power according to rotation of the wind turbine 101. For example, the AC input unit 102 generates three-phase AC power and supplies it to the rectifier 103. The rectifier (rectification circuit) 103 is an AC/DC converter that rectifies the AC power and converts it into DC power. The rectifier 103 converts the three-phase AC power generated by the AC input unit 102 into DC power. The rectifier 103 includes diodes (e.g., FRD: Fast Recovery Diodes) D101 and D102 connected in series. A plurality of pairs of the diodes D101 and D102 are connected in parallel. In this example, three pairs of the diodes D101 and D102 are connected in parallel so as to perform three-phase full-wave rectification on the three-phase AC power. The AC power is input to an intermediate node between each pair of the diodes D101 and D102.

The booster (booster chopper circuit) 104 boosts the DC power generated by the rectifier 103. The booster 104 includes an inductor L101, a diode D103, a capacitor C101, and an IGBT circuit 106. The inductor L101 and the diode D103 are connected in series between the rectifier 103 (the cathode side of the diode D101) and the inverter 100 (high side). The IGBT circuit 106 is connected in parallel to the diodes D101 and D102 between the inductor L101 and the diode D103 (anode side). Further, the capacitor C101 is connected in parallel to the IGBT circuit 106 between the diode D103 (cathode side) and the inverter 100. The boosting is performed by controlling on/off of the IGBT circuit 106 by a control circuit for boosting (not shown).

The inverter 100 is a DC/AC converter that converts boosted DC power to AC power under the control of the inverter control unit 113. In the inverter 100, the IGBT circuit (high side switch) 111a and the IGBT circuit (low side switch) 111b constitute an IGBT module 110. A plurality of the IGBT modules 110 are connected in parallel. In this example, in order to generate the three-phase AC power, three IGBT modules 110 are connected in parallel. The AC power is output from an intermediate node between each pair of the IGBT circuits 111a and 111b. As described later, each of the IGBT circuits 111a and 111b is composed of a plurality of IGBT elements connected in parallel. For example, in an inverter for high power applications, 2 to 12 IGBT elements are connected in parallel.

The driver module 112 is provided for each IGBT module because the IGBT module 110 is controlled by per IGBT module basis. The driver module 112 generates the AC power by controlling on/off of the IGBT circuits 111a and 111b in accordance with an instruction from the inverter control unit 113. For example, the IGBT circuit 111 (one or both of 111a and 111b) and the driver module 112 constitute a drive system (inverter system) 120. By applying the IGBT module according to this embodiment to the inverter system, the operations can be carried out at a high speed, and thus power can be efficiently converted.

The AC output unit 105 is a load of a destination to which the AC power is output. The AC output unit 105 is a power system, a motor, or the like. The AC output unit 105 includes an inductor L102 and an AC load circuit 107. The three-phase AC power is supplied to the AC load circuit 107 via the inductor L102.

### <Configuration of IGBT of First Embodiment>

Next, a configuration example of the IGBT element included in the IGBT circuit 111 of the inverter 100 according to this embodiment will be described.

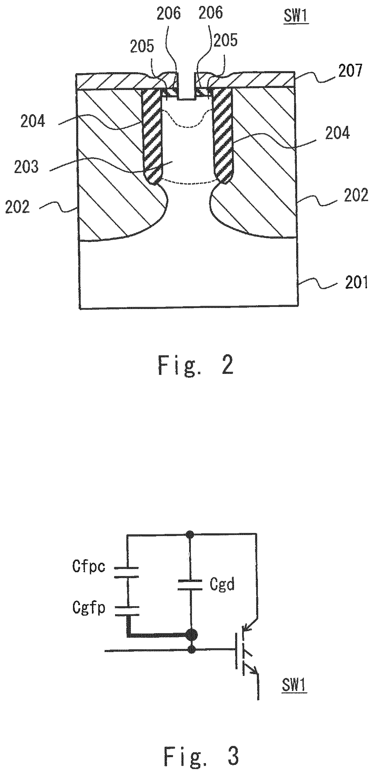

Fig. 2 shows a schematic cross-section of an IGBT element SW1 as an example. Fig. 3 shows a configuration of an equivalent circuit of Fig. 2. The example of Fig. 2 is an IGBT structure including a common floating layer. Since a trench electrode is formed alongside the gate-gate, it is called a GG structure. With such a configuration, it is possible to handle higher power.

As shown in Fig. 2, in the IGBT element SW1 having the GG structure, an N-drift layer 201 is formed on a collector electrode (not shown). P-type floating layers 202 are formed on the N-drift layer 201 at predetermined intervals. An N-type hole barrier layer 203 is formed between P-type floating layers 202. A P-type channel region 205 (contact layer) and an N-type emitter region (emitter layer) 206 are formed on the N-type hole barrier layer 203.

Gate electrodes (trench gates) 204 are formed on both sides of the N-type emitter region 206 and the P-type channel region 205. The gate electrode 204 is formed in a trench reaching between the N-type hole barrier layer 203 and the P-type floating layer 202 from the N-type emitter region 206 and the P-type channel region 205. An insulating film 207 is formed to cover the P-type floating layers 202, the gate electrodes 204, and the N-type emitter region 206. An emitter electrode (not shown) is formed in a trench reaching the N-type emitter region 206 and the P-type channel region 205 (contact layer) from the insulating film 207.

In the IGBT element SW1 having the GG structure as shown in Fig. 2, a parasitic capacitance as shown in Fig. 3 is generated. In the IGBT element SW1, floating capacitances Cfpc and Cgfp through the respective P-type floating layers 202 and a gate capacitance Cgd through the N-type hole barrier layer 203 become a collector-gate capacitance.

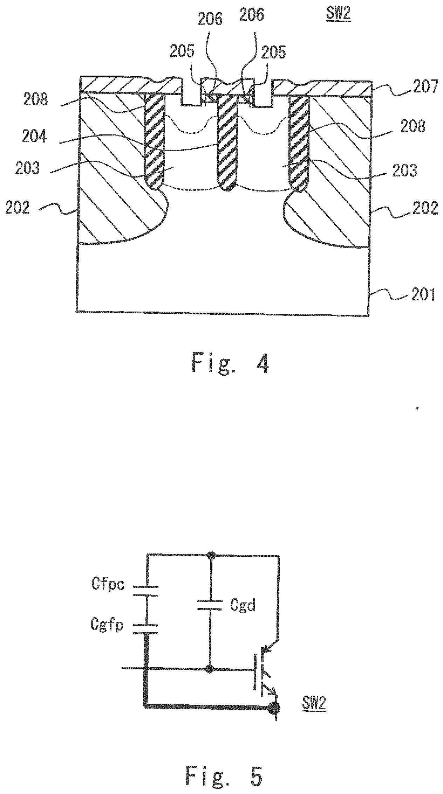

Fig. 4 shows another example of a schematic cross-section of the IGBT element SW2. Fig. 5 shows a configuration of an equivalent circuit of Fig. 4. The example of Fig. 4 is an IGBT structure in which the capacitance component through the floating layer is reduced. This IGBT structure is referred to as an EGE structure because the trench electrodes are formed in parallel to the emitter-gate-emitter. This structure can handle higher power and higher speed.

As shown in Fig. 4, an IGBT element SW2 having the EGE structure has a configuration of the trench electrode different from that of the IGBT element SW1 of Fig. 2. Specifically, the N-type emitter regions (emitter layers) 206 are formed at the center of the P-type channel regions 205 (contact layers). The gate electrodes (trench gates) 204 are formed at the center of the P-type channel regions 205 and the N type emitter regions 206. The gate electrodes 204 are formed in trenches reaching the N-type hole barrier layers 203 from the N-type emitter regions 206 and the P-type channel regions 205. Emitter electrodes (trench emitters) 208 are formed on both sides of the P-type channel regions 205. The emitter electrodes 208 are formed in trenches reaching between the N-type hole barrier layers 203 and the P-type floating layers 202 from the P-type channel regions 205.

In the IGBT element SW2 having the EGE structure as shown in Fig. 4, a parasitic capacitance as shown in Fig. 5 is generated. In the IGBT element SW2, since the floating capacitances Cfpc and Cgfp through the P-type floating layer 202 are connected between the collector and the emitter, the collector-gate capacitance is only the gate capacitance Cgd through the N-type hole barrier layer 203. Therefore, in the EGE structure, a feedback capacitance (Cres) can be greatly reduced compared with the GG structure. Accordingly, high-speed switching becomes possible.

### <Configuration of IGBT Module of Study Example>

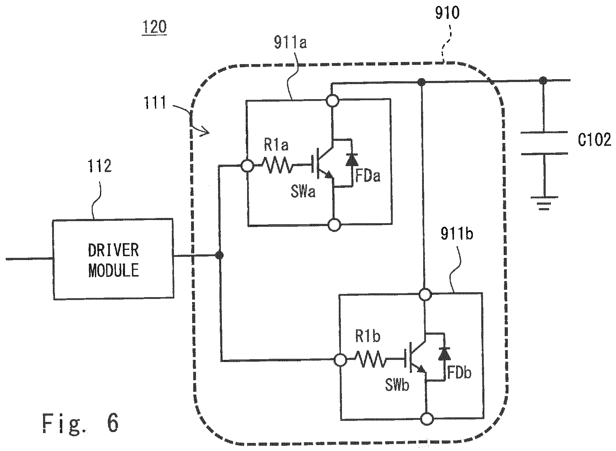

First, an IGBT module of Study Example before this embodiment is applied will be described. Fig. 6 shows a configuration of a drive system including the IGBT module of Study Example.

As shown in Fig. 6, an IGBT module 910 of Study Example includes a plurality of IGBT mounting units (mounting boards) 911. The plurality of the IGBT mounting unit 911 correspond to the IGBT circuits 111 (111a or 111b) in Fig. 1, respectively. In this example, two IGBT mounting units 911a and 911b are connected in parallel.

The IGBT mounting unit 911a and 911b have the same configuration. The IGBT mounting unit 911a and 911b include IGBT elements SW (SWa and SWb), diodes FD (FDa and FDb: Free Wheeling Diode), and resistors R1 (R1a and Rib), respectively. A diode FD is connected between the collector and the emitter of the IGBT element SW. A resistor R1 (damping resistor) is connected to the gate of the IGBT element SW. The gates of a plurality of IGBT elements SW are commonly connected via the resistor R1. The collectors are commonly connected as well. Note that the emitters of the plurality of IGBT elements SW are also commonly connected (not shown). The driver module 112 is connected to a common node of the gates. A control voltage (gate voltage) is supplied from the driver module 112. The AC load circuit 107 is connected to a common node of the collectors. In this example, the capacitance C102 is connected to the common node of the collectors. Note that the gate is referred to as a control terminal. Any one of the collector and the emitter (the source and the drain in the case of a MOSFET) may be referred to as a first terminal or a second terminal.

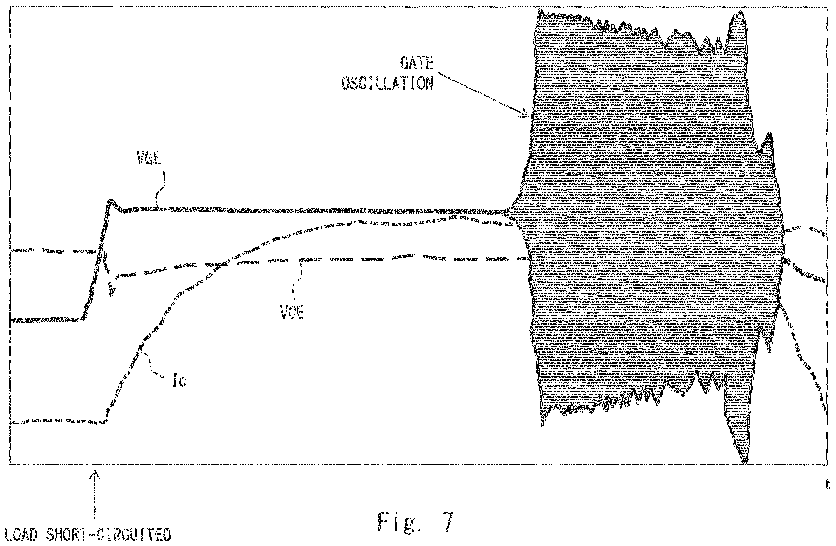

In such a configuration, there is a problem that gate oscillation occurs when the load is short-circuited (grounded). Fig. 7 shows signal waveforms of the IGBT element SW when the load is short-circuited. As shown in Fig. 7, when the load is short-circuited, the fluctuations in the gate-emitter voltage VGE and the collector-emitter voltage VCE are small. However, a collector current Ic increases, and a saturation current continues to flow. Then, when a certain oscillation condition (resonance condition) is satisfied due to an influence of the temperature characteristic and the like, the state of the gate-emitter voltage VGE becomes oscillated (gate oscillation).

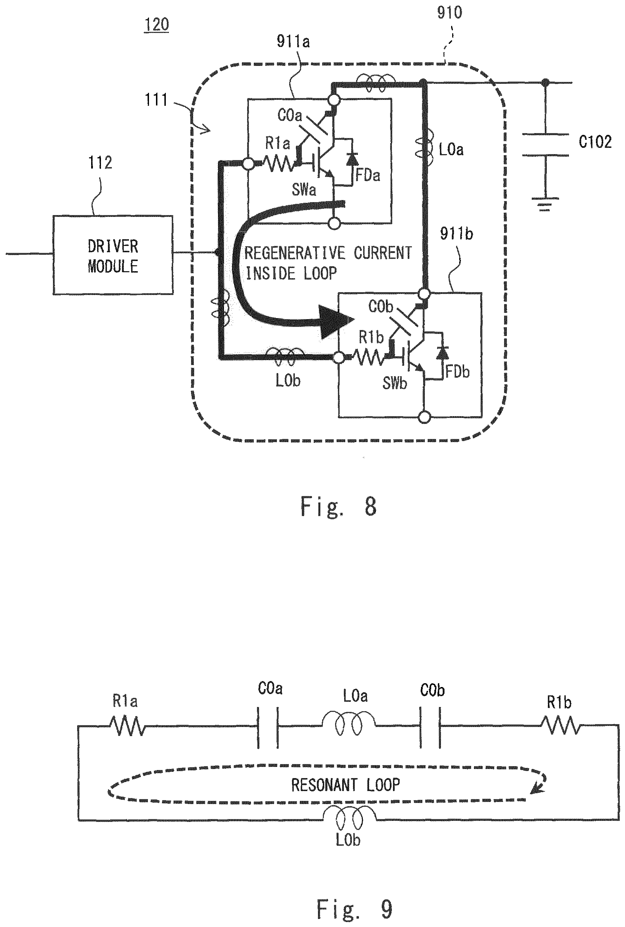

This oscillation is caused by a resonant loop formed by the parallel connection of the IGBTs when the load is short-circuited. Fig. 8 shows parasitic components of the resonant loop. Fig. 9 shows an equivalent circuit of the resonant loop. As shown in Fig. 8, a gate capacitance (collector-gate) capacitance COa is generated in the IGBT mounting unit 911a, a gate capacitance (collector-gate) capacitance C0b is generated in the IGBT mounting unit 911b, a parasitic inductor LOa is generated between the collectors of the IGBT mounting units 911a and 911b, and a parasitic inductor LOb is generated between the gates of the IGBT mounting sections 911a and 911b. Then, as shown in Fig. 9, a regenerative current flows through the resonant loop that includes the resistor R1a, the gate capacitance C0a, the parasitic inductor LOa, the gate capacitance C0b, the resistor R1b, and the parasitic inductor L0b. For this reason, when the parasitic inductor component in the resonant loop is large, or when the feedback capacitance (gate capacitance) of each element is small, oscillation as shown in Fig. 7 is generated while the load is short-circuited, which is a problem.

Recently, as the number of parallel connections of the IGBTs tends to increase along with the increase in the output power, the parasitic inductor component tends to increase. Further, there are requests for reducing the feedback capacitance in order to reduce the switching loss. For this reason, how to optimize design of devices/modules for the purpose of achieving a reduction in noise/oscillation has become an issue.

For example, with the IGBT element SW2 having the above EGE structure, it is possible to greatly reduce the switching loss as compared with the IGBT element SW1 having the GG structure. However, with the IGBT element SW2 having the above EGE structure, due to an extremely small feedback capacitance, oscillation occurs when the IGBT elements SW2 are connected in parallel. In order to prevent this oscillation, the resistance values of the gate resistors (R1a and R1b) in the oscillation loop may be increased. However, if the resistance values of the gate resistors are increased, high-speed switching cannot be performed. Therefore, in this embodiment, the following IGBT module structure is employed to reduce the influence on the switching characteristics and to prevent generation of the gate oscillation.

### <Configuration of IGBT Module According to First Embodiment>

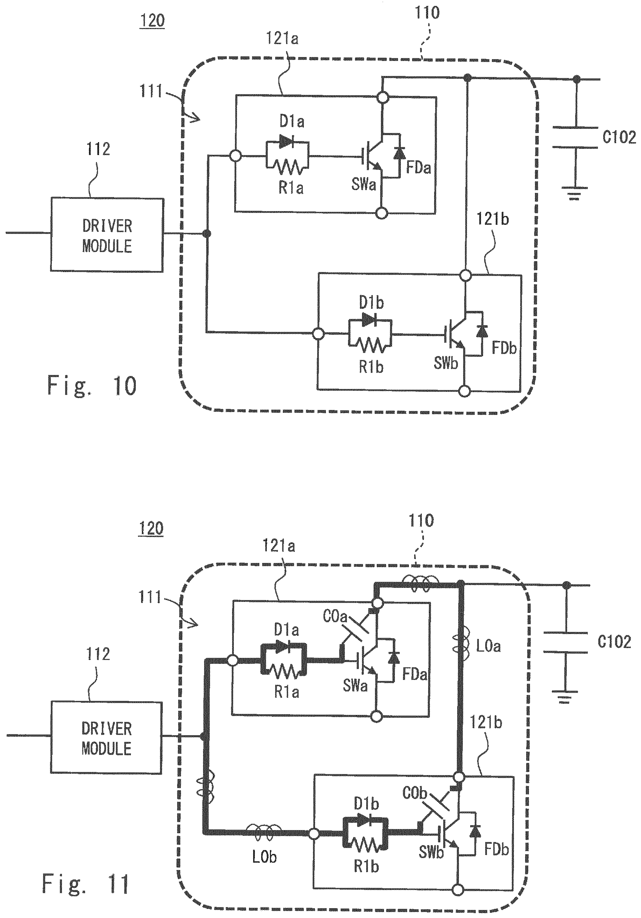

Fig. 10 shows the configuration of the IGBT module according to this embodiment. As shown in Fig. 10, an IGBT module 110 according to this embodiment includes a plurality of IGBT mounting units (mounting boards) 121. The plurality of IGBT mounting units 121 correspond to the IGBT circuits 111 (111b or 111a) in Fig. 1, respectively.

The IGBT mounting units 121 (121a and 121b) include diodes D1 (D1a and D1b) in addition to the configuration of Study Example of Fig. 6. The diodes D1 (first and second diodes) are connected in parallel to the resistors R1 (first and second resistors) that are connected to the gates of the IGBT elements SW, respectively. In each of the diodes D1, the anode is connected to the driver module 112 side (common node side), and the cathode is connected to the gate side of the IGBT element SW. The direction toward the gate is a forward direction. The diodes D1 and the resistors R1 may be formed inside the IGBT mounting units 121 (semiconductor chips), respectively, or may be external components. A Schottky barrier diode (SBD) or the like may be used as the diode. The configuration other than the diode D1 is the same as that in Fig. 6.

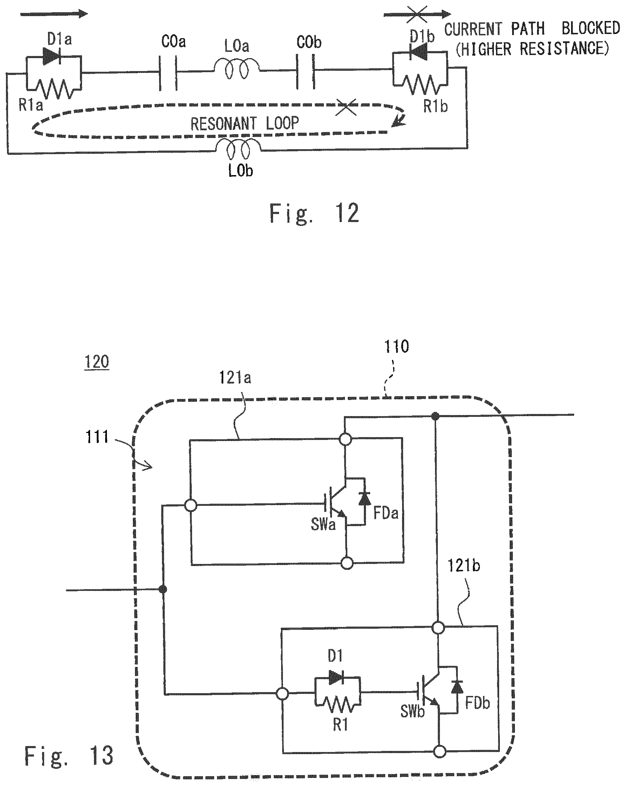

Fig. 11 shows parasitic components of a resonant loop in the configuration of Fig. 10. Fig. 12 shows an equivalent circuit of the resonant loop. As shown in Fig. 11, like the configuration of Fig. 8, a gate capacitance C0a is generated in the IGBT mounting unit 121a, a gate capacitance C0b is generated in the IGBT mounting unit 121b, a parasitic inductor LOa is generated between the collectors of the IGBT mounting units 121a and 121b, and a parasitic inductor LOb is generated between the gates of the IGBT mounting units 121a and 121b. Then, as shown in Fig. 12, the resonant loop will become a resonant loop including the resistor R1a and the diode D1a that are connected in parallel, the gate capacitance C0a, the parasitic inductor L0a, the gate capacitance COb, the resistor R1b and the diode D1b that are connected in parallel, and the parasitic inductor L0b.

Although a regenerative current in the resonant loop flows through the diode D1a, it tends to flow through the resistor R1b because the diode D1b is in the reverse direction and the current path is blocked. Therefore, the resistance of the resistor R1b (damping resistor) may be increased to thereby reduce the oscillation. Further, since the gate direction of the diodes D1 (D1a and D1b) is the forward direction, the impedance of the gate charge path at the time of turn-on can be maintained low. Thus, an increase in the switching loss can also be prevented, and the operations can be performed at a high speed.

When two IGBTs are connected in parallel, there is one resonant loop. Thus, as shown in Fig. 13, a parallel circuit composed of the diode D1 and the resistor R1 may be inserted into the gate of at least one IGBT element SW. When three or more IGBTs are connected in parallel, there are a plurality of resonant loops. Thus, it is preferable that a parallel circuit composed of the diode D1 and the resistor R1 be inserted into each of the gates of the IGBT elements SW. Further, the present disclosure is not limited to the IGBT elements and instead a power transistor such as a power MOSFET and the like (a gate-driven three-terminal amplifying element) may be used. That is, as shown in Fig. 13, the IGBT module (semiconductor apparatus) 110 may include the IGBT element SWb (the first power transistor) and the IGBT element SWa (the second power transistor) that are connected in parallel, the resistor R1 (the first resistor) connected to the gate (the control terminal) of the IGBT element SWb, and the diode D1 (the first diode) connected in parallel to the resistor R1. In this diode D1, the direction toward the gate is a forward direction.

As described above, in this embodiment, in the drive system in which the IGBTs are connected in parallel, the forward diode and the resistor that are connected in parallel are inserted into the gate input unit of each IGBT. With such a configuration, it is possible to prevent an increase in the switching loss and to inhibit the oscillation.

As in the above Study Example, it is effective to increase the damping effect by increasing the resistance values in the resonant loop as a measurement for preventing the oscillation. However, if individual gate resistance values are increased, the feature of the high-speed switching included in the device cannot be fully utilized. There has been a problem of trade-off between oscillation suppression withstand capability and switching characteristics. For this reason, in Study Example, even if high-speed IGBTs such as the EGE structure are used, the advantage there of cannot be fully utilized. However, by using the IGBTs in the drive system to which this embodiment is applied, it is possible to make full use of the features of high-speed switching also in applications for parallel connection. In such a case, the degree of freedom in optimization design of device/module can be improved.

### Second Embodiment

In this embodiment, Implementation Example of the IGBT module according to the first embodiment will be described.

### <Reference Example>

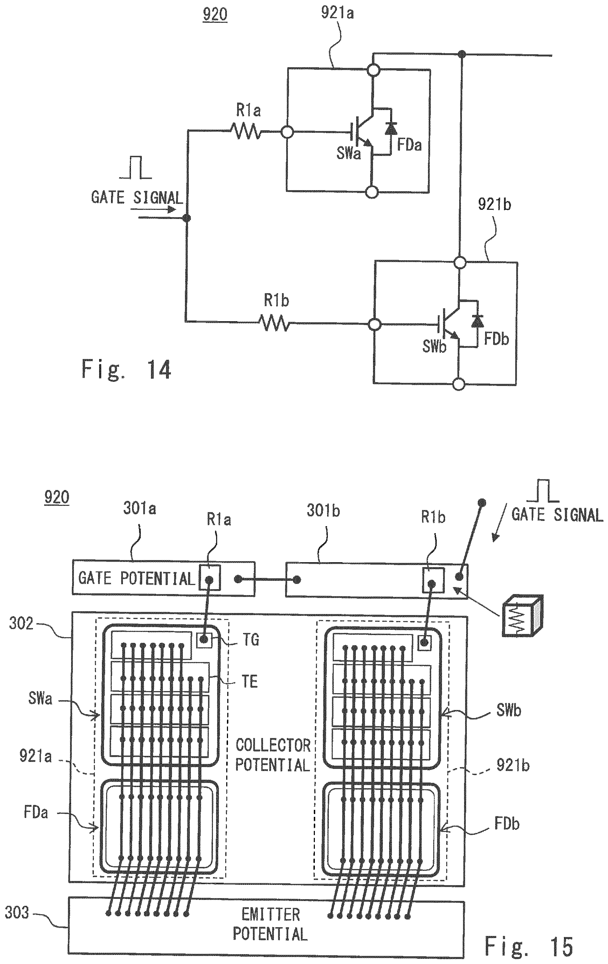

Fig. 14 shows a configuration of an IGBT module according to Reference Example before the embodiments are applied. Fig. 15 shows the Reference Example. This Reference Example is an example in which only a resistor is inserted into the gate of the IGBT as in the above-described Study Example.

As shown in Fig. 14, an IGBT module 920 of Reference Example includes IGBT mounting units 921a and 921b. The IGBT mounting units 921a and 921b include IGBT elements SWa and SWb and diodes FDa and FDb, respectively. Resistors R1a and R1b are externally connected to the gate terminals of the IGBT mounting units 921a and 921b, respectively.

As shown in Fig. 15, Implementation Example of the IGBT module 920 of Reference Example includes gate potential regions (pattern: first mounting region) 301a and 301b, a collector potential region (pattern: second mounting region) 302, and an emitter potential region (pattern) 303. Each region is an island on which the respective elements are to be mounted. Each region is a base plate formed of a copper plate. In this example, in each of the IGBT elements (IGBT chips) SWa and SWb, collector terminals (backside terminals) are formed on a rear surface (not shown), and emitter terminals (pads) TE and gate terminals (pad) TG (frontside terminals) are formed on a front surface.

The IGBT elements (IGBT chips) SWa and SWb are mounted in the collector potential region 302. The backside terminals (collector terminals) of the IGBT elements SWa and SWb are electrically connected to the collector potential region 302. Diodes (diode chips) FDa and FDb are mounted in the collector potential region 302. Backside terminals (cathode terminals) of the diodes FDa and FDb are electrically connected to the collector potential region 302.

The resistors R1a and R1b are surface mount chip resistors. The resistor R1a is mounted in a gate potential region 301a, and the backside terminal of the resistor R1a is electrically connected to the gate potential region 301a. The resistor R1b is mounted in the gate potential region 301b, and the backside terminal of the resistor R1b is electrically connected to the gate potential region 301b.

A plurality of emitter terminals TE on the front surface of the IGBT elements SWa and SWb are electrically connected to the emitter potential region 303 by wires through the frontside terminals (anode terminals) of the diodes FDa and FDb, respectively. The gate terminals TG on the surface of the IGBT elements SWa and SWb are electrically connected to the frontside terminals of the resistors R1a and R1b, respectively, by wires. The gate potential regions 301a and 301b are electrically connected to each other by a wire. For example, the gate potential region 301b is electrically connected to the driver module 112. Gate signals are input to the gate potential regions 301a and 301b.

### <Implementation Example 1>

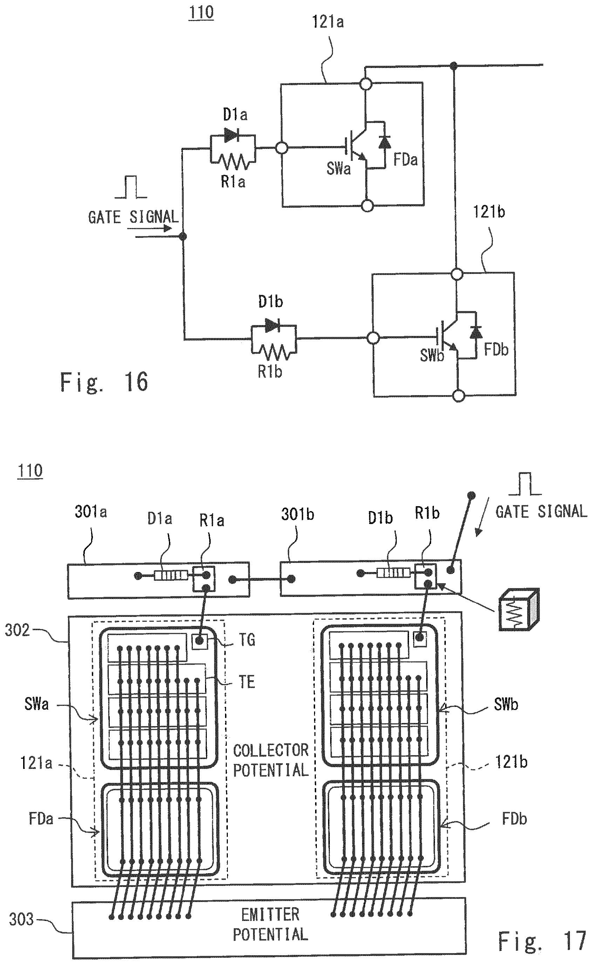

Fig. 16 shows a configuration example for achieving the IGBT module according to the first embodiment. Fig. 17 shows Implementation Example 1 of Fig. 16.

As shown in Fig. 16, an IGBT module 110 according to this embodiment includes IGBT mounting units 121a and 121b. The IGBT mounting units 121a and 121b have the same configuration as that of the IGBT mounting units 921a and 921b of Reference example, respectively. The resistor R1a and the diode D1a, the resistor R1b and the diode D1b are externally connected to the gate terminals.

As shown in Fig. 17, in Implementation Example 1 of the IGBT module 110 according to this embodiment, the diode D1a is mounted in a gate potential region 301a. The anode terminal of the diode D1a is electrically connected to the gate potential region 301a, and the cathode terminal of the diode D1a is electrically connected to the frontside terminal of the resistor R1a (surface mount chip resistor). Likewise, the diode D1b is mounted in the gate potential region 301b. The anode terminal of the diode D1b is electrically connected to the gate potential region 301b, and the cathode terminal of the diode D1b is electrically connected to the frontside terminal of the resistor R1b. Configuration other than the above components is the same as that of Reference Example.

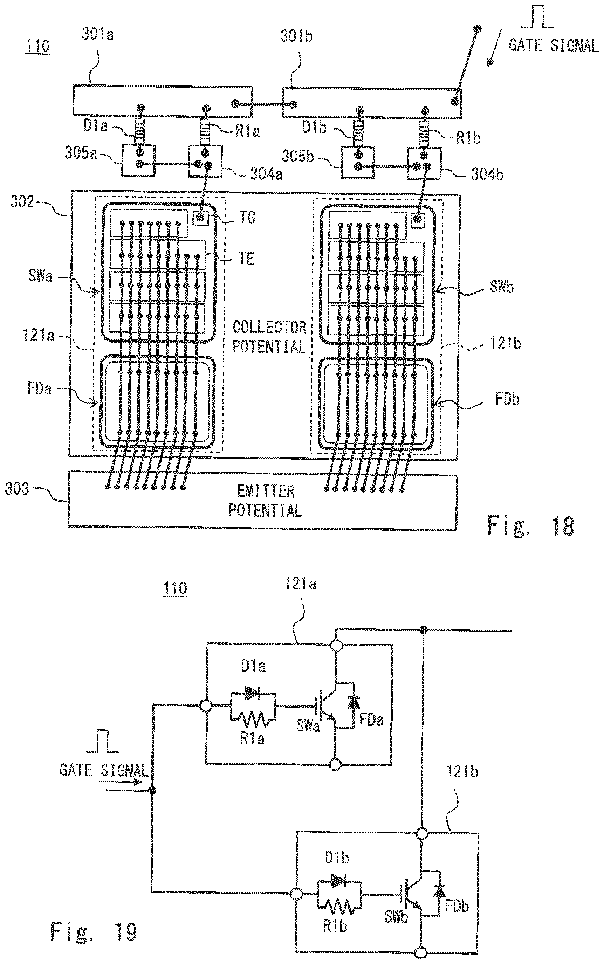

Fig. 18 shows another Implementation Example. Fig. 18 shows an example in which a lead type resistor is used as the resistors R1a and R1b. In this case, regions (patterns) 304a and 304b for connecting the resistors and regions (patterns) 305a and 305b for connecting the diodes are required. That is, one end of the resistor R1a is connected to the region 304a, and another end of the resistor R1a is connected to the gate potential region 301a. The anode terminal of the diode D1a is connected to the gate potential region 301a, and the cathode terminal of the diode D1a is electrically connected to the region 304a. Likewise, one end of the resistor R1b is connected to the region 304b, and the other end is connected to the gate potential region 301b. The anode terminal of the diode D1b is connected to the gate potential region 301b, and the cathode terminal of the diode D1b is electrically connected to the region 304b.

Commonly, the shape of the gate node board is determined by whether or not an external resistor is present and the specification of the external resistor. When a surface mount resistor is used, the regions can be implemented by islands (regions) shown in Fig. 15. While when a lead type resistor is used, an independent island connected to a gate pad is necessary.

Therefore, when this embodiment is implemented by lead type resistors, as shown in Fig. 18, it is necessary to change a substrate and to add wiring, which increases the disadvantage in terms of cost. On the other hand, when a surface mount resistor is used, as shown in Fig. 17, this embodiment can be implemented by adding one diode (for each IGBT) without changing the substrate layout to the configuration of Fig. 15. This maintains the versatility of the substrate and minimizes an increase in member cost and mounting process.

As shown in Fig. 18, if two lead resistance/lead diodes are used from the gate pad, the same configuration as the configuration shown in Fig. 18 can be implemented. However, in this case, there may be a limitation in an area of the pad.

### <Implementation Example 2>

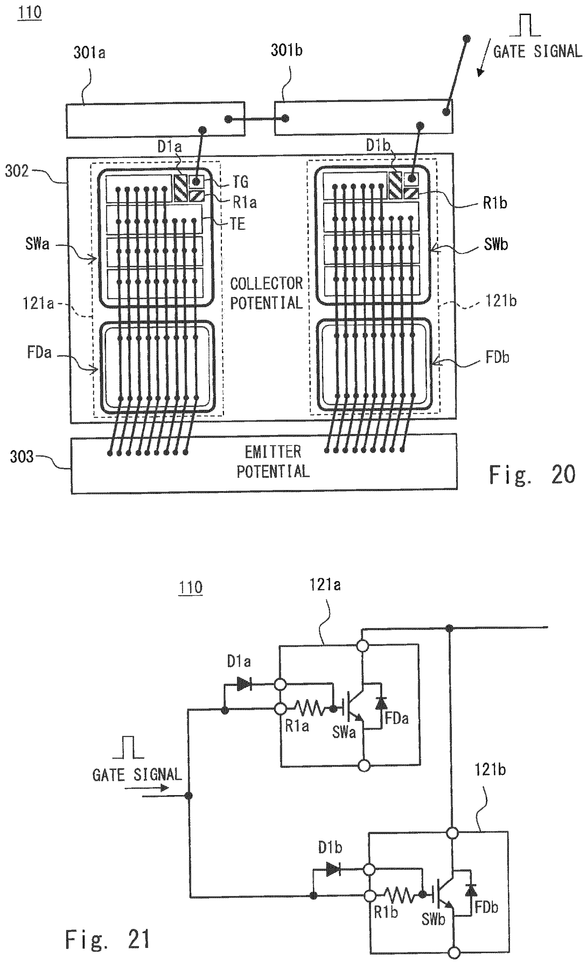

Fig. 19 shows another configuration example for achieving the IGBT module according to the first embodiment. Fig. 20 shows Implementation Example 2 of Fig. 19.

As shown in Fig. 19, an IGBT module 110 according to this embodiment includes IGBT mounting units 121a and 121b. The IGBT mounting units 121a and 121b includes IGBT elements SWa and SWb, diodes FDa and FDb, resistors R1a and R1b, and diodes D1a and D1b, respectively.

As shown in Fig. 20, the resistors R1a and R1b and the diodes D1a and D1b are formed in the IGBT mounting units 121a and 121b in Implementation Example 2 of the IGBT module 110 according to this embodiment. Thus, it is only necessary to connect the gate terminals TG of the IGBT element SWa and SWb to the gate potential regions 301a and 301b, respectively. Configuration other than the above components is the same as that of Fig. 17.

As described above, Implementation Example 2 is an example in which the gate resistors and the parallel diodes are included inside the IGBT chip. Accordingly, this embodiment can be implemented without changing the external component configuration from the configuration before this embodiment is applied.

### <Implementation Example 3>

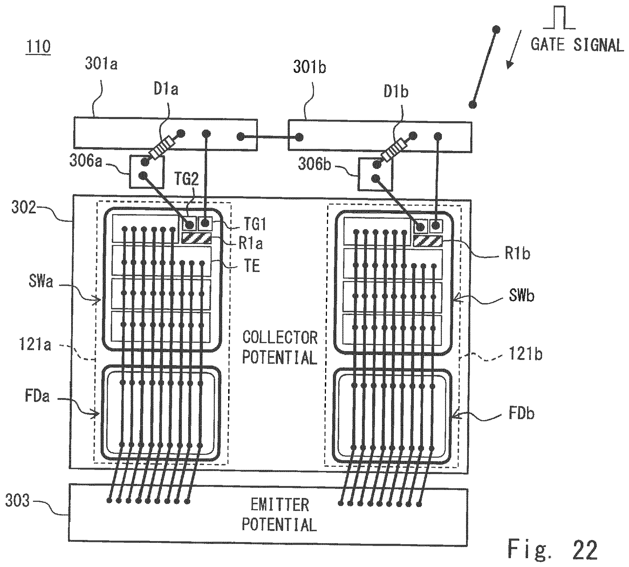

Fig. 21 shows another configuration example for achieving the IGBT module according to the first embodiment. Fig. 22 shows Implementation Example 3 of Fig. 21.

As shown in Fig. 21, an IGBT module 110 according to this embodiment includes IGBT mounting units 121a and 121b. The IGBT mounting units 121a and 121b includes IGBT elements SWa and SWb, diodes FDa and FDb, resistors R1a and R1b, respectively. The diodes D1a and D1b are externally connected to the gate terminals.

As shown in Fig. 22, in Implementation Example 3 of the IGBT module 110 according to this embodiment, the resistors R1a and R1b are formed in the IGBT mounting units 121a and 121b, respectively. Thus, gate terminals TG1 and TG2 at both ends of the resistor R1 are included as frontside terminals of the IGBT elements SWa and SWb. Further, regions (pattern: third mounting region) 306a and 306b for connecting the diodes are included.

In the IGBT mounting unit 121a, the gate terminal TG1 is connected to the gate potential region 301a, the gate terminal TG2 is connected to the region 306a, and the diode D1a is connected between the region 306a and the gate potential region 301a. In the IGBT mounting unit 121b, the gate terminal TG1 is connected to the gate potential region 301b, the gate terminal TG2 is connected to the region 306b, and the diode D1b is connected between the region 306b and the gate potential region 301b. Configuration other than the above components is the same as the configuration of Fig. 17.

As described above, in Implementation Example 3, only the gate resistors are included in the IGBT chips, pads are provided at both ends of the resistors, and parallel diodes are connected thereto. Therefore, this embodiment can be achieved by one external diode (for each IGBT).

Although the invention made by the present inventor has been described in detail based on the embodiments, it is obvious that the present disclosure is not limited to the above embodiments, and various modifications can be made without departing from the scope of the invention.

The first and second embodiments can be combined as desirable by one of ordinary skill in the art.

While the invention has been described in terms of several embodiments, those skilled in the art will recognize that the invention can be practiced with various modifications within the scope of the appended claims and the invention is not limited to the examples described above.

Further, the scope of the claims is not limited by the embodiments described above.

## Claims

1. A semiconductor apparatus (110) comprising:
first and second power transistors (SWb, SWa) connected in parallel to each other;
a first resistor (R1) connected to a first control terminal of the first power transistor; and
a first diode (D1) connected in parallel to the first resistor,
wherein in the first diode, a direction toward the first control terminal of the first power transistor is a forward direction,
a second control terminal of the second power transistor and the first control terminal of the first power transistor are adapted to be commonly controlled,
the first control terminal of the first power transistor is connected with both one end of the first resistor and one end of the first diode,
a first mounting region on which a semiconductor chip is mounted, the semiconductor chip including the first power transistor, the first resistor, a first gate terminal connected via the first resistor to the first control terminal, and a second gate terminal directly connected to the first control terminal;
a second mounting region connected to the first gate terminal and connected to the second gate terminal via a third mounting region, the second mounting region being adapted to be supplied with a control signal for the first control terminal; and
the one end of the first diode is mounted on the third mounting region and another end of the first diode is mounted on the second mounting region.

2. The semiconductor apparatus according to Claim 1, further comprising:
a second resistor connected to the second control terminal of the second power transistor; and
a second diode connected in parallel to the second resistor,
wherein in the second diode, a direction toward the second control terminal of the second power transistor is a forward direction.

3. The semiconductor apparatus according to Claim 1 or 2, wherein the first and second power transistors are IGBT elements.

4. The semiconductor apparatus according to Claim 3, wherein the IGBT element includes a gate-gate structure in which first and second trench gates are arranged with a channel region interposed therebetween.

5. The semiconductor apparatus according to Claim 3 or 4, wherein the IGBT element includes an emitter-gate-emitter structure in which first and second trench emitters are arranged with a channel region and a trench gate interposed therebetween.

6. An inverter system comprising:
an inverter comprising the semiconductor apparatus according to any one of Claims 1 to 5.

## Patentansprüche

1. Halbleitervorrichtung (110), umfassend:
einen ersten und einen zweiten Leistungstransistor (SWb, SWa), die zueinander parallelgeschaltet sind;
einen ersten Widerstand (R1), der mit einem ersten Steueranschluss des ersten Leistungstransistors verbunden ist; und
eine erste Diode (D1), die zum ersten Widerstand parallelgeschaltet ist,
wobei in der ersten Diode eine Richtung in Richtung zum ersten Steueranschluss des ersten Leistungstransistors eine Vorwärtsrichtung ist,
ein zweiter Steueranschluss des zweiten Leistungstransistors und der erste Steueranschluss des ersten Leistungstransistors dazu geeignet sind, gemeinsam gesteuert zu werden,
der erste Steueranschluss des ersten Leistungstransistors mit sowohl einem Ende des ersten Widerstands als auch einem Ende der ersten Diode verbunden ist,
einen ersten Montagebereich, auf welchem ein Halbleiterchip installiert ist, wobei der Halbleiterchip den ersten Leistungstransistor, den ersten Widerstand, einen ersten Gate-Anschluss, der über den ersten Widerstand mit dem ersten Steueranschluss verbunden ist, und einen zweiten Gate-Anschluss, der direkt mit dem ersten Steueranschluss verbunden ist, enthält;
einen zweiten Montagebereich, der mit dem ersten Gate-Anschluss verbunden ist und mit dem zweiten Gate-Anschluss über einen dritten Montagebereich verbunden ist, wobei der zweite Montagebereich dazu geeignet ist, dass ihm ein Steuersignal für den ersten Steueranschluss zugeführt wird; und
das eine Ende der ersten Diode auf dem dritten Montagebereich installiert ist und ein weiteres Ende der ersten Diode auf dem zweiten Montagebereich installiert ist.

2. Halbleitervorrichtung nach Anspruch 1, weiterhin umfassend:
einen zweiten Widerstand, der mit dem zweiten Steueranschluss des zweiten Leistungstransistors verbunden ist; und
eine zweite Diode, die zum zweiten Widerstand parallelgeschaltet ist,
wobei in der zweiten Diode eine Richtung in Richtung zum zweiten Steueranschluss des zweiten Leistungstransistors eine Vorwärtsrichtung ist.

3. Halbleitervorrichtung nach Anspruch 1 oder 2, wobei der erste und der zweite Leistungstransistor IGBT-Elemente sind.

4. Halbleitervorrichtung nach Anspruch 3, wobei das IGBT-Element eine Gate-Gate-Struktur enthält, bei welcher erste und zweite Graben-Gates mit einem dazwischen eingefügten Kanalbereich angeordnet sind.

5. Halbleitervorrichtung nach Anspruch 3 oder 4, wobei das IGBT-Element eine Emitter-Gate-Emitter-Struktur enthält, bei welcher erste und zweite Graben-Emitter mit einem Kanalbereich und einem Graben-Gate dazwischen eingefügt angeordnet sind.

6. Wechselrichtersystem, umfassend:
einen Wechselrichter, der die Halbleitervorrichtung nach einem der Ansprüche 1 bis 5 umfasst.

## Revendications

1. Un appareil semi-conducteur (110) comprenant :
des premier et deuxième transistors de puissance (SWb, SWa) connectés en parallèle l'un à l'autre ;
une première résistance (R1) connectée à une première borne de commande du premier transistor de puissance ; et
une première diode (D1) connectée en parallèle à la première résistance,
dans la première diode, une direction vers la première borne de commande du premier transistor de puissance étant une direction vers l'avant,
une deuxième borne de commande du deuxième transistor de puissance et la première borne de commande du premier transistor de puissance sont adaptées pour être commandées en commun,
la première borne de commande du premier transistor de puissance est connectée à la fois à une extrémité de la première résistance et à une extrémité de la première diode,
une première zone de montage sur laquelle une puce semi-conductrice est montée, la puce semi-conductrice comprenant le premier transistor de puissance, la première résistance, une première borne de grille connectée via la première résistance à la première borne de commande, et une deuxième borne de grille directement connectée à la première borne de commande ;
une deuxième zone de montage connectée à la première borne de grille et connectée à la deuxième borne de grille via une troisième zone de montage, la deuxième zone de montage étant adaptée pour être alimentée avec un signal de commande pour la première borne de commande ; et
une extrémité de la première diode est montée sur la troisième zone de montage et une autre extrémité de la première diode est montée sur la deuxième zone de montage.

2. L'appareil semi-conducteur selon la revendication 1, comprenant en outre :
une deuxième résistance connectée à la deuxième borne de commande du deuxième transistor de puissance ; et
une deuxième diode connectée en parallèle à la deuxième résistance ;
dans la deuxième diode, une direction vers la deuxième borne de commande du deuxième transistor de puissance étant une direction vers l'avant.

3. L'appareil semi-conducteur selon la revendication 1 ou la revendication 2, dans lequel les premier et deuxième transistors de puissance sont des éléments IGBT.

4. L'appareil semi-conducteur selon la revendication 3, dans lequel l'élément IGBT comprend une structure grille-grille dans laquelle des première et deuxième portes de tranchée sont agencées avec une zone de canal interposée entre elles.

5. L'appareil semi-conducteur selon la revendication 3 ou la revendication 4, dans lequel l'élément IGBT comprend une structure émetteur-grille-émetteur dans laquelle des premier et deuxième émetteurs de tranchée sont agencés avec une zone de canal et une grille de tranchée interposée entre elles.

6. Un système onduleur comprenant :
un onduleur comprenant l'appareil semi-conducteur selon l'une quelconque des revendications 1 à 5.
